# EUROPEAN PATENT APPLICATION

(11) **EP 1 806 427 A2**
(43) Date of publication of application: **11.07.2007**
(21) Application number: 07250016.8
(22) Date of filing: 04.01.2007
(51) Int. Cl.: C23C 16/30, H01L 45/00

(54) **Method of forming phase change material thin film, and method of manufacturing phase change memory device using the same**

(30) Priority: 10.01.2006 KR 20060002692
(71) Applicant: Samsung Electronics Co., Ltd., Suwon-si, Gyeonggi-Do (KR)
(72) Inventor: Shin, Woong-chul c/o Samsung Advanced Inst. Tech., Gyeonggi-do (KR); Khang, Yoon-ho c/o Samsung Advanced Inst. Tech., Gyeonggi-do (KR)
(74) Representative: Kyle, Diana

(57) **Abstract**

A method of forming a phase change material thin film and a method of fabricating a phase change memory device using the same are provided. The method of forming a phase change material thin film comprises supplying a first precursor including Ge and a second precursor including Te into a reaction chamber concurrently, thereby forming a GeTe thin film on a substrate; supplying a second precursor including Te and a third precursor including Sb onto the GeTe thin film concurrently, thereby forming a SbTe thin film; and repeatedly performing the supplying of the first and second precursors and the supplying of the second and third precursors, thereby forming a GeSbTe thin film. When a phase change layer is formed using the formation method for fabrication of a semiconductor memory device, memory characteristics is improved, and the fabrication processing provides simplified processes and reduced production costs.

## Description

### BACKGROUND OF THE INVENTION

### 1. Field of the Invention

The present invention relates to a method of forming a phase change material thin film and a method of manufacturing a phase change memory device using the same, and more particularly, to a method of forming a phase change material thin film having excellent thin film characteristics using an organic metal chemical vapor deposition method, and a method of manufacturing a phase change memory device using the same.

### 2. Description of the Related Art

Development of various electronic instruments and expansion of their application fields accelerate development of a memory device performing a data storage function in such an electronic instrument.

The memory device suitable for the instrument basically requires nonvolatile characteristics that its stored data is remained thereinside even when power supply is shut down.

Also, the memory device requires characteristics of low price, high integration density, low power consumption, high speed, and the like in terms of competitiveness in markets.

A typical example of such a nonvolatile memory device is a flash memory, but it has a defect of a low operating speed.

Therefore, under development are various memory devices, which have the nonvolatile characteristics and a capacity of the flash memory or higher, and can operate very fast.

As a typical nonvolatile memory device, there are a magnetoresistance random access memory (MRAM) using that directions of magnetic spins are different from each other, a ferroelectric random access memory (FRAM) using a polarization phenomenon of ferroelectrics, a phase-change random access memory (PRAM) using a phase change material in which a phase of a thin film is changed by an external energy, and the like.

The PRAM stores data using the resistance difference between an amorphous state and a crystal state of a chalcogenide material whose phase is changeable by externally applied energy. That is, the PRAM stores data in the state of '0' or '1' using the resistance difference caused by reversible phase transition of a phase change material layer composed of germanium (Ge)-antimony (Sb)-tellurium (Te) (GST) as chalcogenide compound in accordance with an amplitude and a length of applied pulse.

Particularly, a reset current required for transition to an amorphous state of a high resistance, and a set current used for transition to a crystal state of a low resistance are transferred from a transistor disposed below through a lower electrode to a phase change material layer so as to cause phase transition. An upper portion of the lower electrode is connected to the phase change material layer, and a lower portion of the lower electrode is connected to a contact being in contact with a drain of the transistor.

As above, a typical PRAM and a method of fabricating the same are disclosed in Korea Registered Patent No. 437,458; Korea Patent Publication No. 2005-31160; US Patent No. 5,825,046; US Patent No. 5,596,522, and the like.

In the methods of fabricating the PRAM device disclosed in the Patents as listed above, since a phase change material layer composed of GST is formed using a physical vapor deposition (PVD) process such as a sputtering process or an evaporation deposition process, the methods have a difficulty in controling a growth rate of the phase change material layer.

As a result, the phase change material layer is not dense in its structure, and furthermore, the phase change material layer cannot have a face centered cubic (FCC) crystal structure having excellent electrical characteristics. Further, when the phase change material layer is formed using a PVD method, as it is difficult to precisely control a composition ratio of germanium (Ge), antimony (Sb) and tellurium (Te) inside the phase change material layer, the characteristics of the phase change material layer is deteriorated. Further, since a deposition speed of the phase change material layer deposited by the PVD process is low, the method has problems that time and costs required to form the phase change material layer are increased. Further, the PVD method is difficult to employ to the fabrication of devices of a highly-integrated 3D structure since the PVD method has poor step coverage characteristics.

Therefore, the electrical characteristics of the memory device using the phase change material layer formed by the PVD method is deteriorated.

### SUMMARY OF THE INVENTION

The present invention provides a method of forming a phase change material layer having excellent thin film characteristics.

The present invention also provides a method of manufacturing a phase change memory device using the method of forming a phase change material thin film.

According to an aspect of the present invention, there is provided a method of forming a phase change material layer comprising: supplying a first precursor including Ge and a second precursor including Te into a reaction chamber concurrently, thereby forming a GeTe thin film on a substrate; supplying a second precursor including Te and a third precursor including Sb onto the GeTe layer concurrently, thereby forming a SbTe thin film; and repeatedly performing the supplying of the first and second precursors and the supplying of the second and third precursors, thereby forming a GeSbTe thin film.

An inert gas and a reaction gas may be supplied into the reaction chamber during processes comprising the first operation of supplying the first and second precursors, and the second operation of supplying the second and third precursors. After the first operation and the second operation, the method may further comprise performing a purge process of stopping supplying the precursors into the reaction chamber, and supplying an inert gas and a reaction gas, so as to remove the first, second, and third precursors, which are physically attached and non-reacted.

In the first operation, a flow rate of a carrier gas of each precursor of Ge and Te may be 10 to 400 sccm, and a component ratio of the supplied precursors of Ge and Te may be 1 : 1, and a total flow rate of the supplied carrier gases may be 200 sccm.

In the second operation, a flow rate of a carrier gas of each precursor of Te and Sb may be 10 to 400 sccm, and a component ratio of the supplied precursors of Te and Sb may be 3 : 2, and a total flow rate of the supplied carrier gases may be 200 sccm.

Each precursor may be supplied at a temperature of 300 to 500°C for 0.1 to 3.0 sec. under a pressure of 0.5 to 10 Torr.

In each operation of the first operation, the second operation, and the purge operation, a supplied inert gas may use argon (Ar) gas or nitrogen (N₂) gas, and a supplied reaction gas may use hydrogen (H₂) gas or ammonia (NH₃) gas.

The phase change material thin film may be formed by repeatedly performing the first operation, the second operation, and the purge operation as one cycle.

According to another aspect of the present invention, there is provided a method of manufacturing a phase change memory device comprising forming a lower electrode on a substrate having lower component elements of a memory device formed thereon; forming a phase change material thin film on the lower electrode; and forming an upper electrode on the phase change material thin film. The forming of the phase change material thin film comprises: supplying a first precursor including Ge and a second precursor including Te into a reaction chamber concurrently, so as to form a GeTe thin film on the substrate; supplying a second precursor including Te and a third precursor including Sb onto the GeTe thin film concurrently, so as to form a SbTe thin film; and repeatedly performing the supplying of the first and second precursors and the supplying of the second and third precursors, so as to form a GeSbTe layer.

An inert gas and a reaction gas may be supplied into the reaction chamber during processes comprising the first operation of supplying the first and second precursors, and the second operation of supplying the second and third precursors.

After the first operation and the second operation, the method may further comprise performing a purge process of stopping supplying the precursors into the reaction chamber, and supplying an inert gas and a reaction gas, so as to remove the first, second, and third precursors, which are physically attached and non-reacted.

### BRIEF DESCRIPTION OF THE DRAWINGS

The above and other features and advantages of the present invention will become more apparent by describing in detail exemplary embodiments thereof with reference to the attached drawings in which:
FIG. 1 is a flow diagram illustrating a method of forming a phase change material thin film according to an embodiment of the present invention in accordance with processing sequences;
FIG. 2 is a processing timing sheet illustrating a method of forming a phase change material thin film according to an embodiment of the present invention;
FIG. 3 is a graph illustrating component ratios of Ge, Sb, and Te in a phase change material thin film according to an embodiment of the present invention;
FIG. 4 is a graph illustrating X-ray diffraction analysis of the crystal structure of a phase change material thin film according to an embodiment of the present invention;
FIG. 5 is an electron microscope photograph illustrating the surface of a phase change material thin film according to an embodiment of the present invention;
FIGS. 6A through 6K are sectional views of processing illustrating a method of manufacturing a phase change semiconductor memory device according to an embodiment of the present invention; and
FIGS. 7A through 7E are sectional views of processing illustrating a method of manufacturing a phase change semiconductor memory device according to an embodiment of the present invention.

### DETAILED DESCRIPTION OF THE INVENTION

Hereinafter, a method of forming a phase change material thin film and a method of manufacturing a phase change memory device using the same will be explained in reference to accompanying drawings.

The present invention is not limited to the embodiments set forth herein, but may be embodied in many different forms within the scope of the present invention by those skilled in this art.

In the drawings, like numbers refer to like elements throughout the specification. The thicknesses of layers and regions are exaggerated for clarity. In addition, when it is described that one layer is positioned 'on' another layer or substrate, the layer can be directly formed on another layer or substrate, or the third layer can be positioned between one layer and another layer or substrate.

### A method of forming a phase change material thin film

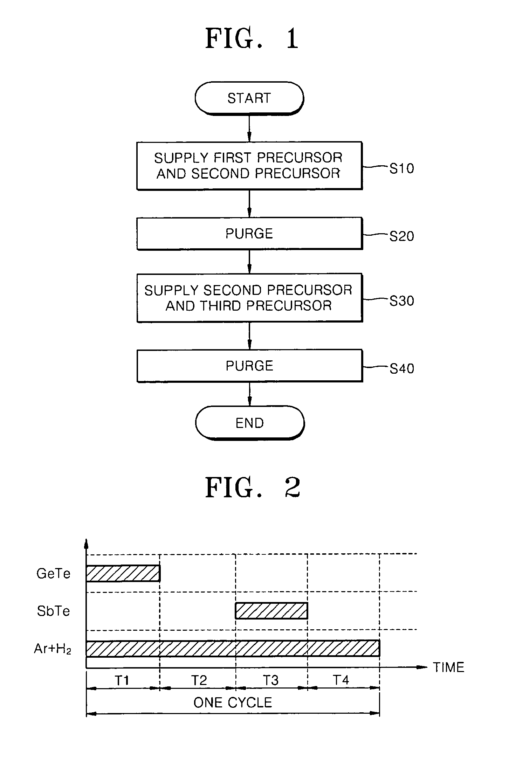

FIG. 1 is a flow diagram illustrating a method of forming a phase change material thin film according to an embodiment of the present invention in accordance with processing sequences. FIG. 2 is a processing timing sheet illustrating a method of forming a phase change material thin film according to an embodiment of the present invention.

Referring to FIGS. 1 and 2, a first precursor including germanium (Ge), a second precursor including tellurium (Te), and a third precursor including antimony (Sb) are prepared. The first, second, and third precursors are (CH₂CH=CH₂)₄Ge, Te(i-C₃H₇)₂, and Sb(i-C₃H₇)₃ respectively.

Further, the first precursor may be at least one selected from the group consisting of (CH₃)₄Ge, (C₂H₅)₄Ge, (n-C₄H₉)₄Ge, (i-C₄H₉)₄Ge, (C₆H₅)₄Ge, (CH₂=CH)₄Ge, (CH₂CH=CH₂)₄Ge, (CF₂=CF)₄Ge, (C₆H₅CH₂CH₂CH₂)₄Ge, (CH₃)₃(C₆H₅)Ge, (CH₃)₃(C₆H₅CH₂)Ge, (CH₃)₂(C₂H₅)₂Ge, (CH₃)₂(C₆H₅)₂Ge, CH₃(C₂H₅)₃Ge, (CH₃)₃(CH=CH₂)Ge, (CH₃)₃(CH₂CH=CH₂)Ge, (C₂H₅)₃(CH₂CH=CH₂)Ge, (C₂H₅)₃(C₅H₅)Ge, (CH₃)₃GeH, (C₂H₅)₃GeH, (C₃H₇)₃GeH, Ge(N(CH₃)₂)₄, Ge(N(CH₃)(C₂H₅))₄, Ge(N(C₂H₅)₂)₄, Ge(N(i-C₃H₇)₂)₄, and Ge[N(Si(CH₃)₃)₂]₄.

The second precursor may be at least one selected from the group consisting of Te(CH₃)₂, Te(C₂H₅)2, Te(n-C₃H₇)₂, Te(i-C₃H₇)₂, Te(t-C₄H₉)₂, Te(i-C₄H₉)₂, Te(Ch₂=CH)₂, Te(CH₂CH=CH₂)₂, and Te[N(Si(CH₃)₃)₂]₂.

The third precursor may be at least one selected from the group consisting of Sb(CH₃)₃, Sb(C₂H₅)₃, Sb(i-C₃H₇)₃, Sb(n-C₃H₇)₃, Sb(i-C₄H₉)₃, Sb(t-C₄H₉)₃, Sb(N(CH₃)₂)₃, Sb(N(CH₃)(C₂H₅))₃, Sb(N(C₂H₅)₂)₃, Sb(N(i-C₃H₇)₂ )₃, and Sb[N(Si(CH₃)₃)_{2]3}.

The precursor may be used singly, or two or more precursors may be mixed and used.

Then, an object where the phase change material thin film will be formed is loaded into a reaction chamber, and an inert gas and a reaction gas are supplied so as to maintain the reaction chamber with a process pressure and a process temperature. Then, a first precursor and a second precursor are concurrently supplied into the reaction chamber for a T1 time, so as to form a GeTe layer (step S10). At this time, the first precursor and the second precursor are supplied onto the object along with their respective carrier gases. The carrier gas includes an inert gas such as argon gas or nitrogen gas. A preferable supply ratio of the precursors, that is, Ge and Te is 1:1, and a flow rate of the supplied carrier gas of each precursor is 10 to 400 sccm. A preferable flow rate of the carrier gas of each precursor of Ge and Te is 100 sccm, and a total flow rate of the carrier gases supplied with the precursors is 200 sccm.

Further, a mixture gas including argon (Ar) as an inert gas and hydrogen (H₂) as a reaction gas is supplied into the reaction chamber as a process gas. The mixture gas is supplied at a flow rate of about 10 to 1000 sccm, preferably about 400 sccm, with a mixture ratio of 1:1. The process gas is continuously supplied until the entire processing operations are completed, and functions to maintain process ambient inside the reaction chamber during the formation of a thin film.

The object may be a semiconductor substrate such as a silicon wafer or an SOI substrate, or a metal oxide single crystal substrate such as an aluminum oxide (Al₂O₃) single crystal substrate, or a strontium titanium oxide (SrTiO₃) single crystal substrate. In this case, an electrode, a conductive layer, a conductive layer pattern, an insulating layer, or an insulating layer pattern may be formed on the object. Thus, the phase change thin film may be directly formed on the object, or may be formed on the electrode, the conductive layer, the conductive layer pattern, the insulating layer, or the insulating layer pattern.

The process of the step S10 is performed at a temperature of 300 to 500°C for 0.1 to 3.0 sec. under a pressure of 0.5 to 10 Torr. Preferably, the process of the step S10 is performed at a temperature of 400°C for 0.9 sec. under a pressure of 2 Torr.

Referring to FIGS. 1 and 2 again, a purge process is performed by stopping the supply of the first precursor and the second precursor into the reaction chamber for a T2 time, and removing the first precursor and the second precursor, which are not chemically deposited and remained inside the reaction chamber, out of the reaction chamber using the inert gas and the reaction gas as the process gas (step S20). More particularly, the inert gas and the reaction gas remove the portions of the first and second precursors, which are physically attached to the chemically-deposited portions thereof on the substrate, and the non-reacted precursors, which are remained inside the reaction chamber.

Referring to FIGS. 1 and 2 again, after the purge process, a second precursor and a third precursor are concurrently supplied into the reaction chamber for a T3 time, so as to form a SbTe layer (step S30). At this time, the second precursor and the third precursor are supplied onto the object along with a carrier gas. The carrier gas includes an inert gas such as argon gas or nitrogen gas.

In the step S30, a preferable supply ratio of the precursors, that is, Te and Sb is 3:2, and a flow rate of a carrier gas of each precursor is 10 to 400 sccm. A preferable flow rate of the carrier gas of each precursor of Te and Sb is 100 sccm, and a total flow rate of the carrier gases supplied with the precursors is 200 sccm.

The process of the step S30 is performed at a temperature of 300 to 500°C for 0.1 to 3.0 sec. under a pressure of 0.5 to 10 Torr. Preferably, the process of the step S30 is performed at a temperature of 400°C for 0.5 sec. under a pressure of 2 Torr.

Referring to FIGS. 1 and 2 again, a process is performed by stopping the supply of the second precursor and the third precursor into the reaction chamber, and removing the second precursor and the third precursor, which are not chemically deposited and remained inside the reaction chamber, out of the reaction chamber for a T4 time (step S40). More particularly, the inert gas and the reaction gas remove the portions of the second and third precursors, which are physically attached to the chemically-deposited portions thereof on the substrate, and the non-reacted precursors, which are remained inside the reaction chamber.

Therefore, a GeSbTe phase change material thin film of a GeTe/SbTe structure having a dense layer property and a low resistance property can be formed on the substrate without use of a plasma process.

According to an embodiment of the present invention, the supply time and the flow rate of the precursors can be controlled, thereby easily controlling component ratios of Ge, Sb, and Te as component elements of the GeSbTe layer.

Further, the steps of S10 through S40 may be repeatedly performed until the GeSbTe thin film is formed with a desired thickness.

When the operations are repeatedly performed by about 50 times, the phase change material thin film is formed on the substrate with a thickness of about 1000 Å.

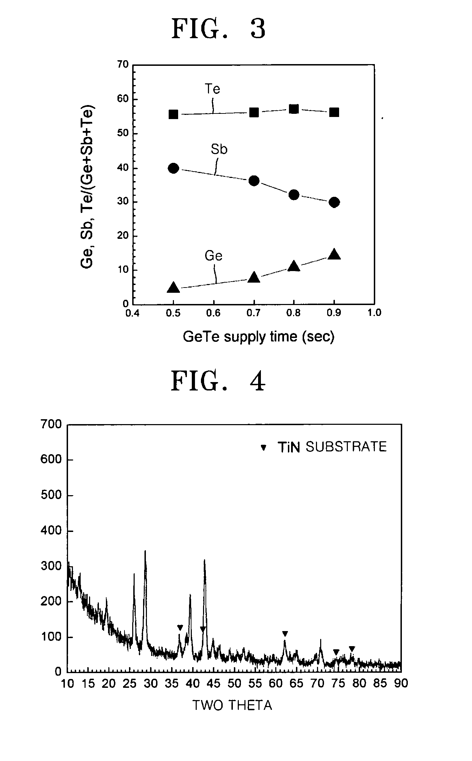

FIG. 3 is a graph illustrating component ratios of Ge, Sb, and Te of the phase change material thin film by the method of forming the phase change material thin film as described above according to an embodiment of the present invention.

The graph illustrates the result of the component ratios when the supply time of the second precursor (Te) and the third precursor (Sb) is fixed to 0.5 sec., and the supply time of the first precursor (Ge) and the second precursor (Te) is changed.

When the supply time of the first precursor and the second precursor is 0.9 sec., a component ratio of GeSbTe of the phase change material thin film is Ge(14.2): Sb(29.8): Te(56.0).

FIG. 4 is a graph illustrating X-ray diffraction analysis of the crystal structure of the phase change material thin film, in which a component ratio of GeSbTe is Ge(14.2): Sb(29.8): Te(56.0), according to an embodiment of the present invention.

Along with an X-ray diffraction peak of a TiN substrate, FIG. 4 illustrates an X-ray diffraction peak of the crystal structure of GeSb₂Te₄, in which a composition ratio is 1: 2: 4.

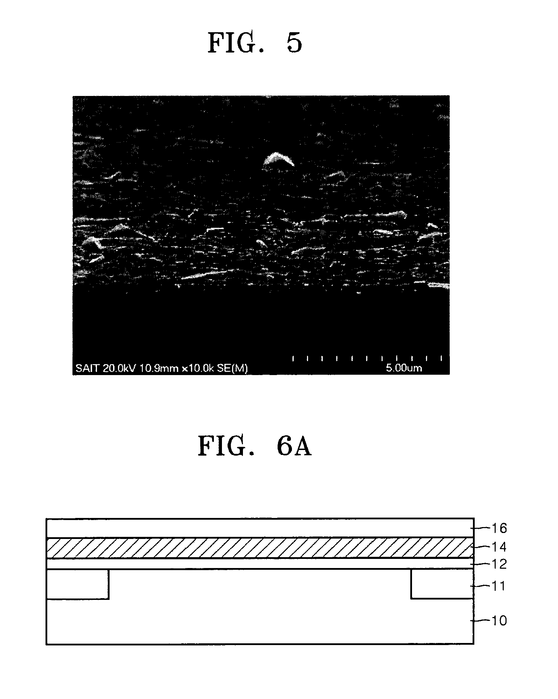

FIG. 5 is an electron microscope photograph illustrating the surface of the phase change material thin film of FIG. 4.

As illustrated in FIG. 5, the surface of the phase change material thin film formed by the method as described above according to an embodiment of the present invention has a very even and dense fine structure.

In the method of forming a GeSbTe thin film according to an embodiment of the present invention, component ratios of the elements can be easily controlled, and a deposition speed of the thin film is high without need of a plasma process, and furthermore, the formation method can be simply and easily performed.

### A method of manufacturing a phase change memory device

### <First embodiment>

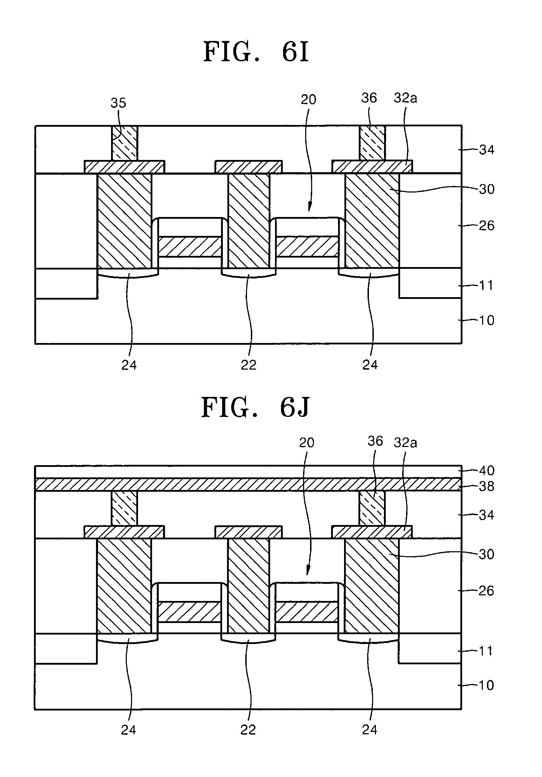

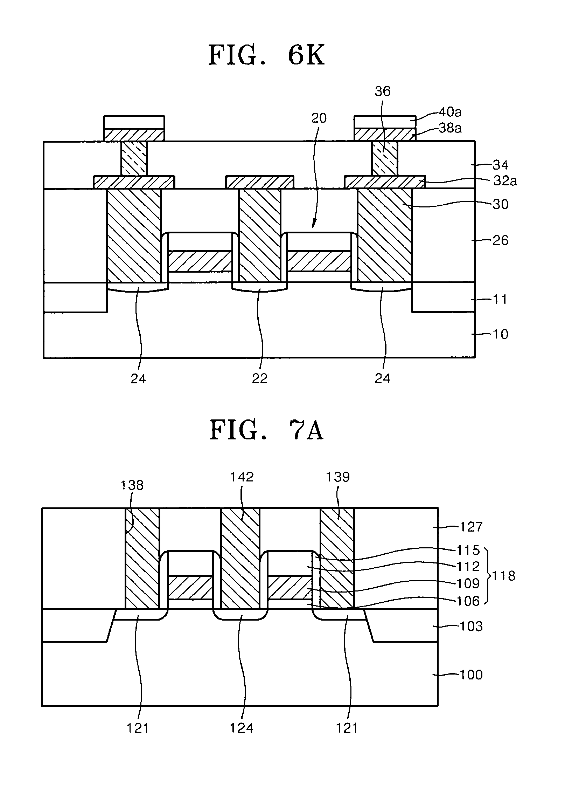

FIGS. 6A through 6H are sectional views of processing illustrating a method of manufacturing a phase change semiconductor memory device according to an embodiment of the present invention.

Referring to FIG. 6A first, a gate insulating layer 12, a gate conductive layer 14, and a gate mask layer 16 are sequentially formed on an active region isolated by an isolation layer 11 in a semiconductor substrate 10.

The gate insulating layer 12 is formed using oxide or metal oxide having a high dielectric constant (high-k). For example, the gate insulating layer 12 is formed using silicon oxide, hafnium oxide, zirconium oxide, titanium oxide, tantalum oxide, or aluminum oxide. The gate insulating layer 12 is formed using a thermal oxidation process, a chemical vapor deposition process, a sputtering process, a plasma-enhanced chemical vapor deposition process, an atomic layer deposition process, or a high density plasma chemical vapor deposition process.

The gate conductive layer 14 is formed using doped polysilicon, metal, or metal silicide. For example, the gate conductive layer 14 is formed using tungsten, aluminum, titanium, tantalum, tungsten silicide, titanium silicide, or cobalt silicide. The gate conductive layer 14 is formed using a chemical vapor deposition process, a sputtering process, a plasma-enhanced chemical vapor deposition process, or an atomic layer deposition process.

The gate mask layer 16 is formed using a material having an etch selectivity with respect to the gate conductive layer 14 and the gate insulating layer 12. For example, the gate mask layer 16 is formed using silicon nitride, silicon oxynitride, or titanium oxynitride. The gate mask layer 16 is formed using a chemical vapor deposition process, a plasma-enhanced chemical vapor deposition process, a sputtering process, or an atomic layer deposition process.

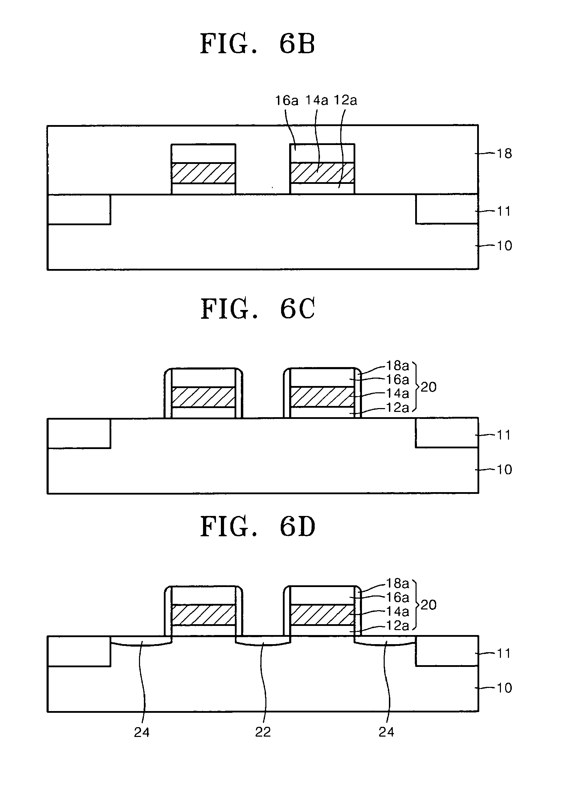

Referring to FIG. 6B, the gate mask layer 16, the gate conductive layer 14, and the gate insulating layer 12 are patterned, thereby forming a gate insulating layer pattern 12a, a gate electrode 14a, and a gate mask 16a, which are sequentially stacked on the semiconductor substrate 10.

Then, a first insulating layer 18 is formed on the semiconductor substrate 10 to cover the gate mask 16a.

Referring to FIG. 6C, the first insulating layer 18 is anisotropically etched, thereby forming a gate spacer 18a on the side walls of the gate insulating layer pattern 12a, the gate electrode 14a, and the gate mask 16a. Thus, a gate structure 20, which consists of the gate insulating layer pattern 12a, the gate electrode 14a, the gate mask 16a, and the gate spacer 18a, is formed on the active region of the semiconductor substrate 10. The first insulating layer 18 is formed using nitride such as silicon nitride.

Referring to FIG. 6D, first and second contact regions 22 and 24 are formed in the exposed semiconductor substrate 10 by an ion implantation process using the gate structure 20 as an ion implantation mask. As a result, a transistor, which includes the gate structure 20 and the first and second contact regions 22 and 24, is formed on the semiconductor substrate 10. For example, the first and second contact regions 22 and 24 are source and drain regions of the transistor respectively. The transistor may be replaced with a PN junction diode.

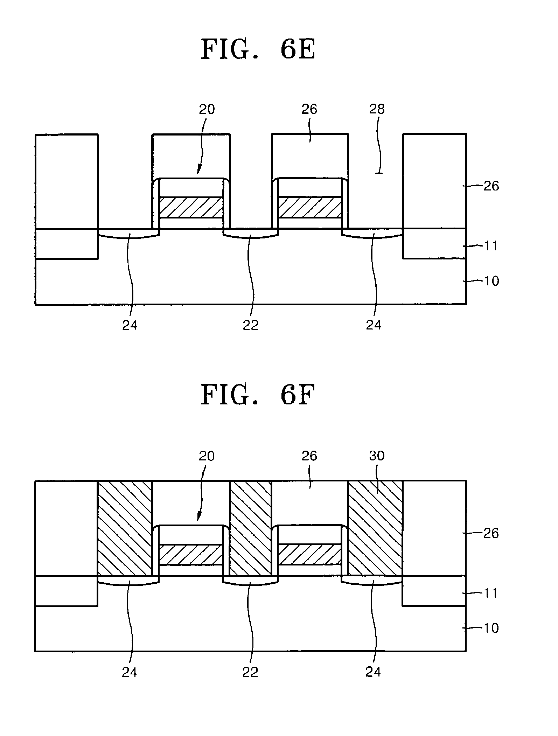

Referring to FIG. 6E, a first interlayer insulating layer 26 is formed on the substrate 10 to cover the transistor. A contact hole 28 is formed in the first interlayer insulating layer 26 so as to expose the first and second contact regions 22 and 24. The first interlayer insulating layer 26 is preferably formed of oxide such as BPSG, PSG, TEOS, PE-TEOS, USG, FOX, SOG, or HDP-CVD oxide. The first interlayer insulating layer 26 is formed using a chemical vapor deposition process, a plasma-enhanced chemical vapor deposition process, an atomic layer deposition process, or a high-density plasma chemical vapor deposition process. The contact hole 28 is formed using an anisotropic etch process.

Referring to FIG. 6F, the contact hole 28 is filled with a conductor 30. The conductor 30 may be formed of impurity-doped polysilicon, metal, or conductive metal nitride. For example, the conductor 30 is formed using tungsten (W), titanium (Ti), tantalum (Ta), aluminum (AI), copper (Cu), tungsten nitride (WN), titanium nitride (TiN), tantalum nitride (TaN), aluminum nitride (AIN), titanium aluminum nitride (TiAIN), and the like. Further, the conductor 30 is formed using a sputtering process, a chemical vapor deposition process, an atomic layer deposition process, an electronic beam deposition process, or a pulse laser deposition (PLD) process. One of a chemical mechanical polishing (CMP) process, an etch-back process, or a combination process including the CMP process and the etch-back process is performed to remove the conductor 30 until the first interlayer insulating layer 26 is exposed.

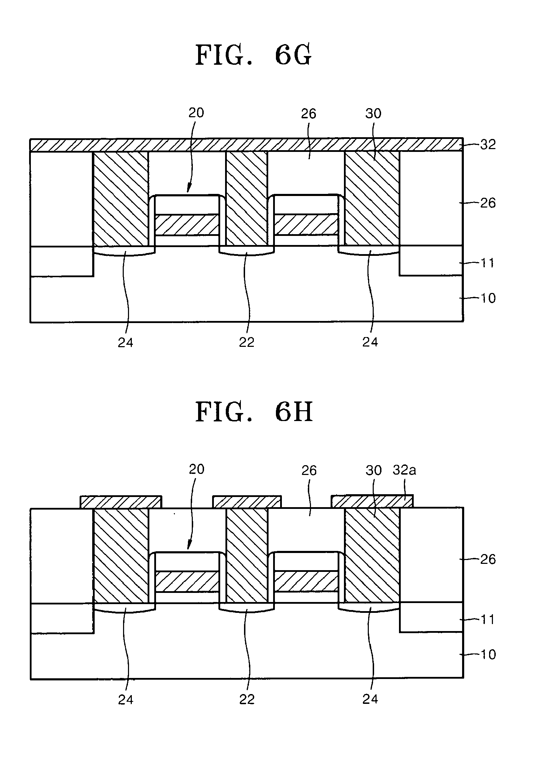

Referring to FIG. 6G, a pad conductive layer 32 is formed on the first interlayer insulating layer 26 including the conductor 30. The pad conductive layer 32 may be formed of impurity-doped polysilicon, metal, or conductive metal nitride. For example, the pad conductive layer is formed using titanium aluminum nitride, tungsten nitride, titanium nitride, tantalum nitride, aluminum nitride, tungsten, titanium, tantalum, aluminum or copper. The pad conductive layer 32 is formed using a sputtering process, a chemical vapor deposition process, an atomic layer deposition process, an electronic beam deposition process, or a pulse laser deposition process. The conductor 30 and the pad conductive layer 32 of the present invention may be formed of a substantially same material among the doped polysilicon, metal, or conductive metal nitride as described above.

Referring to FIG. 6H, a pad pattern 32a is formed by performing a photolithography process and an etch process on the pad conductive layer 32.

Referring to FIG. 6I, a second interlayer insulating layer 34 is formed on the first interlayer insulating layer 26 including the pad pattern 32a. Then, a contact hole 35 is formed on the second interlayer insulating layer 34 to expose the pad pattern 32a. The contact hole 35 is filled with conductor, so as to form a lower electrode 36.

The second interlayer insulating layer 34 includes at least one oxide layer and/or a nitride layer. For example, the oxide layer may be formed using PSG, BPSG, USG, SOG, TEOS, PE-TEOS, FOX, or HDP-CVD oxide, and the nitride layer may be formed using silicon nitride. The second interlayer insulating layer 34 is formed using a chemical vapor deposition process, a plasma-enhanced chemical vapor deposition process, an atomic layer deposition process, or a high density plasma chemical vapor deposition process. According to an embodiment of the present invention, the first interlayer insulating layer 26 and the second interlayer insulating layer 34 may be formed of a substantially same material among the oxide and/or nitride as described above. Alternatively, the first and second interlayer insulating layers 26 and 34 in the embodiment of the present invention may be formed of materials different from each other among the oxide and/or nitride.

The lower electrode 36 may be formed of impurity-doped polysilicon, metal, or conductive metal nitride. For example, the lower electrode 36 is formed using tungsten, titanium, titanium nitride, tantalum, tantalum nitride, molybdenum nitride (MoN), niobium nitride (NbN), titanium silicon nitride (TiSiN), aluminum, titanium aluminum nitride, titanium boron nitride (TiBN), zirconium silicon nitride (ZiSiN), tungsten silicon nitride (WSiN), tungsten boron nitride (WBN), zirconium aluminum nitride (ZrAIN), molybdenum silicon nitride (MoSiN), molybdenum aluminum nitride (MoAIN), tantalum silicon nitride (TaSiN), or tantalum aluminum nitride (TaAIN). This may be used singly, or two or more may be mixed to be used. Further, the lower electrode 36 may be formed using a sputtering process, a chemical vapor deposition process, an electronic beam deposition process, an atomic layer deposition process, or a pulse laser deposition process.

Then, an etch-back process or a chemical mechanical polishing (CMP) process is used to partially remove the conductor for the lower electrode 36 until the second interlayer insulating layer 34 is exposed. Thus, the lower electrode 36 and the pad pattern 32a are connected to each other inside the second interlayer insulating layer 34.

Referring to FIG. 6J, a phase change material thin film 38 and a conductor layer 40 are sequentially formed on the second interlayer insulating layer 34 including the lower electrode 36.

The phase change material thin film 38 includes germanium-antimony-tellurium (GST). As formation processes of the phase change material thin film 38 are the same as the processes described in reference to FIGS. 1 and 2, detailed explanation will be omitted.

The conductor layer 40 may be formed of impurity-doped polysilicon, metal, or conductive metal nitride. For example, the conductor layer 40 is formed of tungsten, titanium, titanium nitride, tantalum, tantalum nitride, molybdenum nitride (MoN), niobium nitride (NbN), titanium silicon nitride (TiSiN), aluminum, titanium aluminum nitride, titanium boron nitride (TiBN), zirconium silicon nitride (ZiSiN), tungsten silicon nitride (WSiN), tungsten boron nitride (WBN), zirconium aluminum nitride (ZrAIN), molybdenum silicon nitride (MoSiN), molybdenum aluminum nitride (MoAIN), tantalum silicon nitride (TaSiN), or tantalum aluminum nitride (TaAIN). This may be used singly, or two or more may be mixed to be used. The conductor layer 40 is formed using a sputtering process, a chemical vapor deposition process, an electronic beam deposition process, an atomic layer deposition process, or a pulse laser deposition process.

Referring to FIG. 6K, the conductor layer 40 and the phase change material thin film 38 are etched using a photolithography process, thereby forming a phase change material thin film pattern 38a and an upper electrode 40a, which are sequentially stacked on the lower electrode 36 and the second interlayer insulating layer 34. More particularly, the phase change material thin film pattern 38a is disposed on the lower electrode 36 and the second interlayer insulating layer 34, and the upper electrode 40a is disposed on the phase change material thin film pattern 38a. Each of the phase change material thin film pattern 38a and the upper electrode 40a has a substantially greater area than that of the lower electrode 36. Then, additional processes are performed so as to complete the fabrication of a memory device. The explanation of subsequent processes will be omitted herein.

### <Second embodiment>

FIGS. 7A through 7E are sectional views of processing illustrating a method of manufacturing a phase change semiconductor memory device according to an embodiment of the present invention.

Referring to FIG. 7A, an isolation layer 103 is formed in a semiconductor substrate 100, so as to define an active region in the semiconductor substrate 100.

A gate insulating layer, a gate conductive layer, and a gate mask layer are sequentially formed on the semiconductor substrate 100, and then, the gate mask layer, the gate conductive layer, and the gate insulating layer are patterned, thereby forming a gate insulating layer pattern 106, a gate electrode 109, and a gate mask 112. According to an embodiment of the present invention, the gate electrode 109 may have a single layer structure such as a doped polysilicon layer, a metal layer, or a conductive metal nitride layer. In an embodiment of the present invention, the gate electrode 109 may have a double-layered structure including a doped polysilicon layer, a metal layer and/or a conductive metal nitride layer. The gate mask 112 is formed using a material having an etch selectivity with respect to the gate electrode 109 and the gate insulating layer pattern 106.

After a first insulating layer is formed on the semiconductor substrate 100 to cover the gate mask 112, the first insulating layer is anisotropically etched, so as to form a gate spacer 118 on the side walls of the gate insulating layer pattern 106, the gate electrode 109, and the gate mask 112. Thus, a gate structure 118, which consists of the gate insulating layer pattern 106, the gate electrode 109, the gate mask 112, and the gate spacer 115, is formed on the semiconductor substrate 100.

An ion implantation process is performed using the gate structures 118 as ion implantation masks, thereby forming first and second contact regions 121 and 124 in the exposed semiconductor substrate 100 between the gate structures 118. As a result, transistors including gate structures 118 and the first and second contact regions 121 and 124 respectively are formed on the semiconductor substrate 100.

A first interlayer insulating layer 127 is formed on the semiconductor substrate 100 to cover the gate structures 118. The first interlayer insulating layer 127 is formed by depositing oxide using a chemical vapor deposition process, a plasma-enhanced chemical vapor deposition process, an atomic layer deposition process, or a high density plasma chemical vapor deposition process.

The first interlayer insulating layer 127 is partially etched using a photolithography process, thereby forming contact holes 138 exposing the first and second contact regions 121 and 124 in the first interlayer insulating layer 127.

A first conductive layer (not shown) is formed on the first interlayer insulating layer 127 to fill the contact holes 138. The first conductive layer is formed by depositing doped polysilicon, metal, or conductive metal nitride, using a sputtering process, a chemical vapor deposition process, a plasma-enhanced chemical vapor deposition process, an atomic layer deposition process, an electronic beam deposition process, or a pulse laser deposition process.

The first conductive layer is partially removed using a chemical mechanical polishing process or an etch-back process, so as to form first and second lower contacts 139 and 142 inside the contact holes 138. The first lower contact 139 is formed on the first contact region 121, and the second lower contact 142 is formed on the second contact region 124.

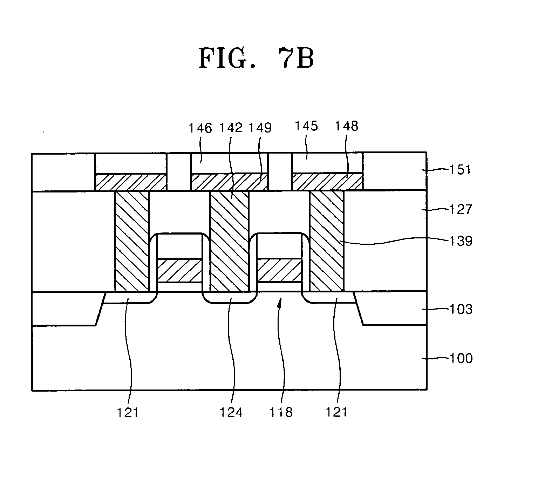

Referring to FIG. 7B, a second conductive layer (not shown) and a second insulating layer (not shown) are sequentially formed on the first and second lower contacts 139 and 142, and the first interlayer insulating layer 127. The second insulating layer is formed by depositing nitride or oxynitride using a chemical vapor deposition process, a plasma-enhanced chemical vapor deposition process, an atomic layer deposition process, or a high density plasma chemical vapor deposition process. Further, the second conductive layer is formed by depositing doped polysilicon, metal, or conductive metal nitride using a sputtering process, a chemical vapor deposition process, an atomic layer deposition process, an electronic beam deposition process, or a pulse laser deposition process.

The second insulating layer is etched using a photolithography process, thereby forming a first insulating layer pattern 145 and a second insulating layer pattern 146 concurrently on the second conductive layer. The first insulating layer pattern 145 is formed over the first lower contact 139, and the second insulating layer pattern 146 is formed over the second lower contact 142.

The second conductive layer is partially etched, using the first and second insulating layer patterns 145 and 146 as etch masks, thereby forming a lower electrode 148 and a lower interconnection 149. The lower electrode 148 is disposed on the first lower contact 139, and is electrically connected to the first contact region 121 through the first lower contact 139. The lower interconnection 149 is disposed on the second lower contact 142, and is electrically connected to the second contact region 124 through the second lower contact 142.

A second interlayer insulating layer 151 is formed to cover the first and second insulating layer patterns 145 and 146 on the first interlayer insulating layer 127. The second interlayer insulating layer 151 is formed by depositing oxide using a chemical vapor deposition process, a plasma-enhanced chemical vapor deposition process, an atomic layer deposition process, or a high density plasma chemical vapor deposition process.

The second interlayer insulating layer 151 is partially removed using an etch-back process or a CMP process until the first and second insulating layer patterns 145 and 146 are exposed. For example, the second interlayer insulating layer 151 is polished using slurry including abrasives containing ceria having a high etch selectivity between oxide and nitride, and the first and second insulating layer patterns 145 and 146 function as polishing stop layers respectively.

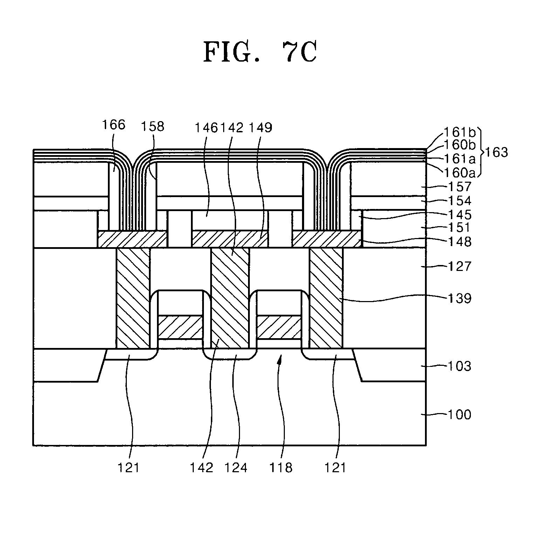

Referring to FIG. 7C, a third insulating layer 154 is formed on the second interlayer insulating layer 151, the first insulating layer pattern 145, and the second insulating layer pattern 146. The third insulating layer 154 is formed by depositing nitride or oxynitride using a chemical vapor deposition process, a plasma-enhanced chemical vapor deposition process, an atomic layer deposition process, or a high density plasma chemical vapor deposition process.

A sacrificial layer 157 is formed on the third insulating layer 154. The sacrificial layer 157 is formed by depositing oxide using a chemical vapor deposition process, a plasma-enhanced chemical vapor deposition process, an atomic layer deposition process, or a high density plasma chemical vapor deposition process.

The sacrificial layer 157, the third insulating layer 154, and the first insulating layer pattern 145 are partially etched using a photolithography process, so as to form an opening 158 exposing the lower electrode 148.

A fourth insulating layer is formed to fill the opening 158 on the lower electrode 148 and the sacrificial layer 157, and then, the fourth insulating layer is anisotropically etched so as to form a preliminary spacer 166 on the side wall of the opening 158.

A phase change material thin film 163 is formed to bury the opening 158 on the lower electrode 148 and the sacrificial layer 157. Similarly as described above, the phase change material thin film 163 includes a plurality of first composite material layers 160a and 160b, and a plurality of second composite material layers 161a and 161b. The first composite material layers 160a and 160b include germanium and tellurium, and the second composite material layers 161a and 161b include antimony and tellurium. The phase change material thin film 163 is formed using the substantially same processes as those described in reference to FIGS. 1 and 2.

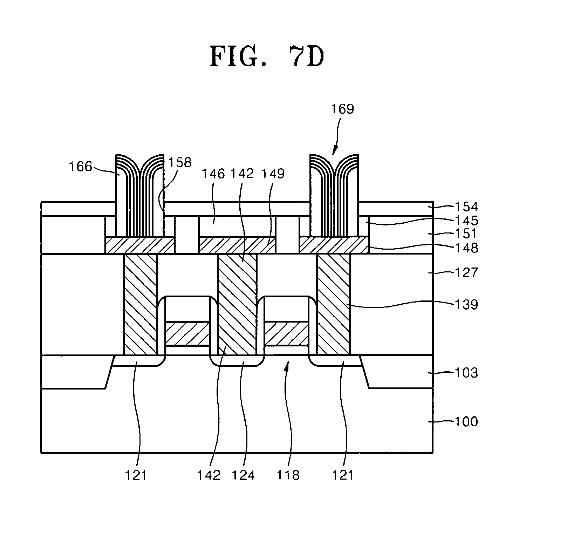

Referring to FIG. 7D, the phase change material thin film 163 is partially removed using a CMP process until the sacrificial layer 157 is exposed, so as to form a preliminary phase change material thin film pattern 169 buried in the opening 158. In this case, a preliminary spacer 166 is disposed between the side wall of the preliminary phase change material thin film pattern 169 and the side wall of the opening 158.

The sacrificial layer 157 is removed using an etching, so as to expose the third insulating layer 154. When the sacrificial layer 157 is removed, the preliminary phase change material thin film pattern 169 and the preliminary spacer 166 are upwardly protruded from the third insulating layer 154.

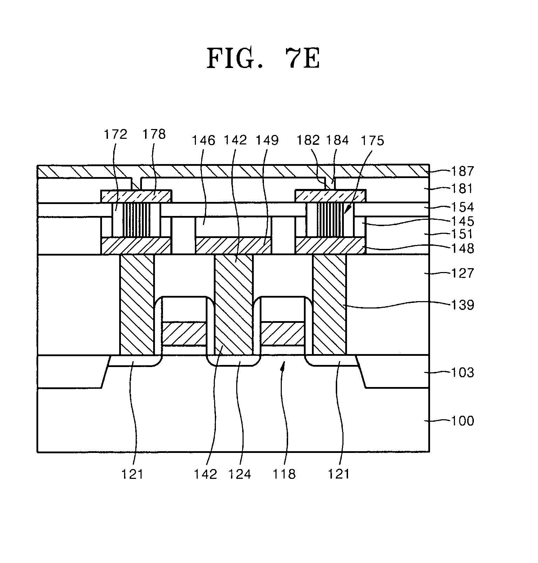

Referring to FIG. 7E, the protruded upper portions of the preliminary phase change material thin film pattern 169 and the preliminary spacer 166 are removed using a CMP process and/or an etch-back process, so as to form a phase change material thin film pattern 175 and a spacer 172 concurrently on the lower electrode 148. For example, the phase change material thin film pattern 175 and the spacer 172 are formed using slurry including abrasives containing ceria, and the third insulating layer 154 functions as a polishing stop layer. According to an embodiment of the present invention, by performing the CMP process sufficiently, the third insulating layer 154 can be removed during the formation of the phase change material thin film pattern 175 and the spacer 172.

An upper electrode 178 is formed on the third insulating layer 154, the spacer 172, and the phase change material thin film pattern 175. The upper electrode 178 is formed by depositing doped polysilicon, metal or conductive metal nitride using a sputtering process, an atomic layer deposition process, an electronic beam deposition process, a chemical vapor deposition process, or a pulse laser deposition process.

A third interlayer insulating layer 181 is formed to cover the upper electrode 178 on the third insulating layer 154. The third interlayer insulating layer 181 is formed by depositing oxide using a chemical vapor deposition process, a plasma-enhanced chemical vapor deposition process, an atomic layer deposition process, or a high density plasma chemical vapor deposition process.

After an upper contact hole 182 exposing the upper electrode 178 is formed in the third interlayer insulating layer 181 using a photolithography process, an upper contact 184 filling the upper contact hole 182 is formed on the upper electrode 178, and concurrently, an upper interconnection 187 is formed on the upper contact 184 and the third interlayer insulating layer 181. The upper contact 184 and the upper interconnection 187 are formed integrally using metal or conductive metal nitride.

Continuously, subsequent processes are performed to complete the fabrication of a memory device. The explanation of the subsequent processes will be omitted herein.

The phase change material thin film formed as above is employed to a recording layer of a phase change memory device. As the phase change material thin film has a reduced reset current, the memory device having the phase change material thin film can be highly integrated, and can operate with a high capacity and a high operating speed.

By the method of forming a phase change material thin film according to the present invention, since the supply of Ge and Te precursors, and the supply of Te and Sb precursors can be performed independently and sequentially so as to form a GeSbTe thin film, the thin film can be provided with a desired composition, and a high quality of the phase change material thin film can be formed compared to that of related art.

Further, by the method of forming a phase change material thin film according to the present invention, a deposition speed of the thin film is high, and the formation method of the thin film is simple and easy. Further, the formation method according to the present invention provides excellent step coverage characteristics, thereby to realize fabrication of a 3D structure of a highly-integrated device.

As the phase change material thin film having excellent phase change characteristics and excellent electrical characteristics formed as above is employed to a recording layer of a phase change memory device, high integration of the device is possible, and a high capacity and a high speed can be provided for the device.

Furthermore, as the phase change material thin film can be formed through simplified processes, time and costs required to fabricate the phase change semiconductor memory device having the phase change material thin film can be dramatically reduced.

## Claims

1. A method of forming a phase change material thin film comprising:
supplying a first precursor including Ge and a second precursor including Te into a reaction chamber concurrently, thereby forming a GeTe thin film on a substrate; and
supplying a second precursor including Te and a third precursor including Sb onto the GeTe thin film concurrently, thereby forming a SbTe thin film.

2. The method according to claim 1, wherein an inert gas and a reaction gas are supplied into the reaction chamber during processes comprising the first operation of supplying the first and second precursors, and the second operation of supplying the second and third precursors.

3. The method according to claim 1 or 2, wherein each of the first through third precursors is supplied along with a carrier gas including argon (Ar).

4. The method according to claim 2, after the first operation and the second operation, which further comprises performing a purge process of stopping supplying the precursors into the reaction chamber, and supplying an inert gas and a reaction gas, so as to remove the first, second, and third precursors, which are physically attached and non-reacted.

5. The method according to claim 4, wherein the inert gas is argon (Ar) or nitrogen (N₂), and the reaction gas is hydrogen (H₂) or ammonia (NH₃).

6. The method according to claim 5, wherein a flow rate of a gas mixture including argon (Ar) and hydrogen (H₂) as the inert gas and the reaction gas is 10 to 1000 sccm.

7. The method according to claim 6, wherein the flow rate of a gas mixture including argon (Ar) and hydrogen (H₂) is 400 sccm.

8. The method according to any of claims 1 to 7, wherein the first precursor comprises at least one selected from (CH₃)₄Ge, (C₂H₅)₄Ge, (n-C₄H₉)₄Ge, (i-C₄H₉)₄Ge, (C₆H₅)₄Ge, (CH₂=CH)₄Ge, (CH₂CH=CH₂)₄Ge, (CF₂=CF)₄Ge, (C₆H₅CH₂CH₂CH₂)₄Ge, (CH₃)₃(C₆H₅)Ge, (CH₃)₃(C₆H₅CH₂)Ge, (CH₃)₂(C₂H₅)₂Ge, (CH₃)₂(C₆H₅)₂Ge, CH₃(C₂H₅)₃Ge, (CH₃)₃(CH=CH₂)Ge, (CH₃)₃(CH₂CH=CH₂)Ge, (C₂H₅)₃(CH₂CH=CH₂)Ge, (C₂H₅)₃(C₅H₅)Ge, (CH₃)₃GeH, (C₂H₅)₃GeH, (C₃H₇)₃GeH, Ge(N(CH₃)₂)₄, Ge(N(CH₃)(C₂H₅))₄, Ge(N(C₂H₅)₂)₄, Ge(N(i-C₃H₇)₂ )₄, and Ge[N(Si(CH₃)₃)₂]₄.

9. The method according to any of claims 1 to 8, wherein the second precursor comprises at least one selected from Te(CH₃)₂, Te(C₂H₅)2, Te(n-C₃H₇)₂, Te(i-C₃H7)₂, Te(t-C₄H₉)₂, Te(i-C₄H₉)₂, Te(Ch₂=CH)₂, Te(CH₂CH=CH₂)₂, and Te[N(Si(CH₃)₃)₂]₂.

10. The method according to any of claims 1 to 9, wherein the third precursor comprises at least one selected from Sb(CH₃)₃, Sb(C₂H₅)₃, Sb(i-C₃H₇)₃, Sb(n-C₃H₇)₃, Sb(i-C₄H₉)₃, Sb(t-C₄H₉)₃, Sb(N(CH₃)₂)₃, Sb(N(CH₃)(C₂H₅))₃, Sb(N(C₂H₅)₂)₃, Sb(N(i-C₃H₇)₂ )₃, and Sb[N(Si(CH₃)₃)₂]₃.

11. The method according to any of claims 3 to 10, wherein a flow rate of the carrier gas of each precursor in the supplying of a first precursor of Ge and a second precursor of Te is 10 to 400 sccm.

12. The method according to claim 11, wherein a component ratio of the supplied precursors of Ge and Te is 1 : 1, and a total flow rate of the supplied carrier gases is 200 sccm.

13. The method according to claim 11 or 12, wherein the precursors of Ge and Te are supplied at a temperature of 300 to 500°C for 0.1 to 3.0 sec. under a pressure of 0.5 to 10 Torr.

14. The method according to any of claims 3 to 13, wherein a flow rate of the carrier gas of each precursor in the supplying of a second precursor of Te and a third precursor of Sb is 10 to 400 sccm.

15. The method of claim 14, wherein a component ratio of the supplied precursors of Te and Sb is 3 : 2, and a total flow rate of the supplied carrier gases is 200 sccm.

16. The method according to claim 14 or 15, wherein the precursors of Te and Sb are supplied at a temperature of 300 to 500°C for 0.1 to 3.0 sec. under a pressure of 0.5 to 10 Torr.

17. The method according to any of claims 1 to 16, wherein the first operation and the second operation as one cycle are repeatedly performed to form the phase change material thin film.

18. A method of manufacturing a phase change memory device comprising:
forming a lower electrode (36) on a substrate (10) having lower component elements of a memory device formed thereon;
forming a phase change material thin film (38) on the lower electrode (36); and
forming an upper electrode (40a) on the phase change material thin film (38), wherein the forming of the phase change material thin film comprises:
supplying a first precursor including Ge and a second precursor including Te into a reaction chamber concurrently, so as to form a GeTe thin film on the substrate; and
supplying a second precursor including Te and a third precursor including Sb onto the GeTe thin film concurrently, so as to form a SbTe thin film.

19. The method according to claim 18, wherein an inert gas and a reaction gas are supplied into the reaction chamber during processes comprising the supplying of the first and second precursors, and the supplying of the second and third precursors.

20. The method according to claim 19, after the first operation of supplying the first and second precursors, and the second operation of supplying the second and third precursors, the method further comprising performing a purge process of stopping supplying the precursors into the reaction chamber, and supplying an inert gas and a reaction gas, so as to remove the first, second, and third precursors, which are physically attached and non-reacted.

21. The method according to any of claims 18 to 20, wherein the inert gas is argon (Ar) or nitrogen (N₂), and the reaction gas is hydrogen (H₂) or ammonia (NH₃).

22. The method according to any of claims 19 to 21, wherein the first operation of supplying the first and second precursors, and the second operation of supplying the second and third precursors are repeatedly performed as one cycle to form the phase change material thin film.

23. The method according to any of claims 18 to 22, wherein each of the precursors, Ge, Te and Sb is supplied along with a carrier gas including argon (Ar) at a flow rate of 10 to 400 sccm.

24. The method according to claim 23, wherein a component ratio of the supplied precursors of Ge and Te is 1 : 1, and a total flow rate of the supplied carrier gases is 200 sccm.

25. The method according to any of claims 18 to 24, wherein the precursors of Ge and Te are supplied at a temperature of 300 to 500°C for 0.1 to 3.0 sec. under a pressure of 0.5 to 10 Torr.

26. The method according to any of claims 23 to 25, wherein a component ratio of the supplied precursors of Te and Sb is 3 : 2, and a total flow rate of the supplied carrier gases is 200 sccm.

27. The method according to claim 26, wherein the precursors of Te and Sb are supplied at a temperature of 300 to 500°C for 0.1 to 3.0 sec. under a pressure of 0.5 to 10 Torr.
